# EUROPEAN PATENT APPLICATION

(11) **EP 0 540 262 A2**
(43) Date of publication of application: **05.05.1993**
(21) Application number: 92309729.9
(22) Date of filing: 23.10.1992
(51) Int. Cl.: H01L 21/76

(54) **Trench isolation region**

(30) Priority: 31.10.1991 US 786022
(71) Applicant: SGS-THOMSON MICROELECTRONICS, INC., Carrollton Texas 75006 (US)
(72) Inventor: Hodges, Robert Louis, Tarrant County, Texas 76040 (US)
(74) Representative: Palmer, Roger

(57) **Abstract**

A method is provided for forming isolated regions of oxide of an integrated circuit, and an integrated circuit formed according to the same. A pad oxide layer is formed over a substrate. A nitride layer is formed over the pad oxide layer. The nitride layer and the pad oxide layer are patterned and etched to form an opening exposing a portion of the substrate. The exposed substrate is then anisotropically etched to form a first trench region. A thermal oxide layer is grown over the exposed substrate in the first trench region and then etched to expose the substrate in the bottom of the first trench region. The substrate in the bottom of the first trench region is then isotropically etched to form a second trench region which extends laterally from the first trench region. The remaining thermal oxide layer, the nitride layer and the pad oxide layer are then removed. An oxide passivation layer is grown over the substrate and in the first and second trench regions. An insulating layer is formed over the passivation layer and a portion of the first and second trench regions.

## Description

The present invention relates generally to semiconductor integrated circuits, and more specifically to forming a trench isolation region.

The trend to continue to miniaturize semiconductor integrated circuits to achieve submicron feature sizes and increase the number of devices fabricated on the integrated circuit has required smaller isolation areas between devices. The active areas in which devices are built are typically isolated by a layer of field oxide. However, the technology used to isolate active areas has not kept pace with the ever-decreasing device geometries.

Isolation techniques should meet a variety of requirements. First, active areas should be in close proximity. Second, the leakage current between devices should be negligible.

One method of isolating devices is the method of LOCOS, LOCal Oxidation of Silicon, which produces regions of insulating silicon dioxide between devices. The LOCOS process was a great technological improvement in reducing the area needed for the isolation regions and decreasing some parasitic capacitances. However, LOCOS produces the well known bird's beak effect, or lateral encroachment of the field oxide in the active area. This birdbeaking results in a substantial sacrifice of active area that becomes significant for feature sizes less than 1.5 microns.

A considerable amount of effort has gone into developing isolation regions between active devices which maintain the integrity of the devices and increase the packing density. One approach is the trench isolation scheme. For example, in CMOS devices, a trench provides a bird-beak free isolation between n-and p-channel devices. The distance around the trench needs to be long enough to prevent leakage from occurring between adjacent source/drain regions of different transistors.

It would be desirable to decrease the spacing between active areas without decreasing the effective isolation distance. It would be further desirable for such method to be compatible with current process techniques.

The invention may be incorporated into a method for forming an integrated circuit, and the integrated circuit formed thereby, by forming a trench isolation region. A trench is formed in a substrate having a first and a second region wherein the first region has vertical sidewalls extending downward from an upper portion of the trench and wherein the second region extends outward from a lower portion of the first region. An insulating layer is formed in a portion of the first and second regions.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:

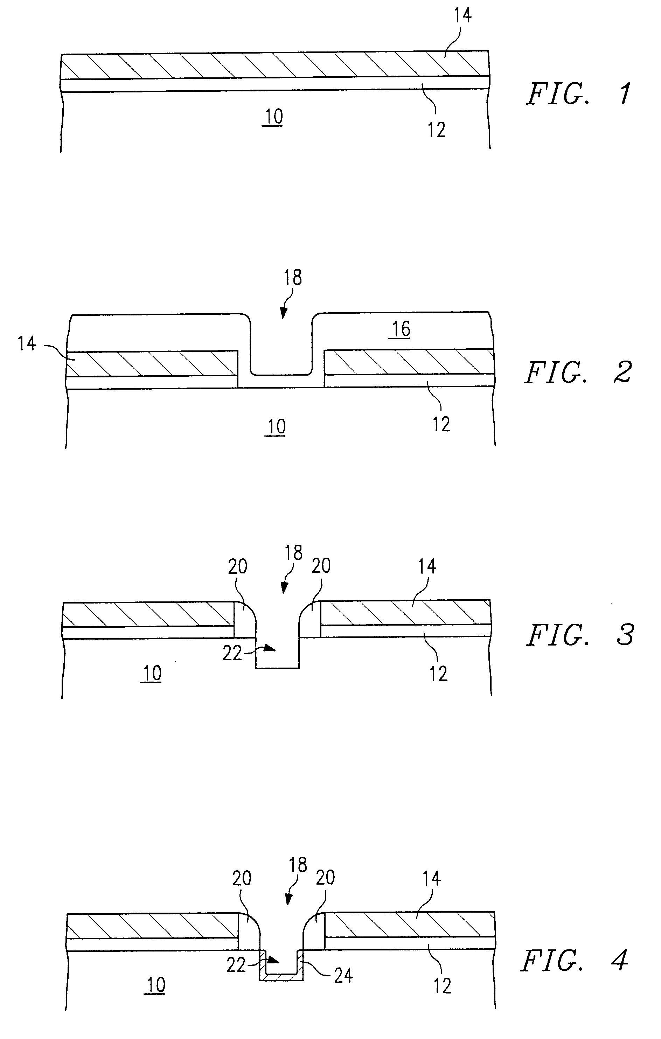

**Figures 1-9** are cross-sectional views of the fabrication of a semiconductor device structure according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to Figure 1, an integrated circuit is to be formed on a silicon substrate 10. A pad oxide layer 12 is formed over the substrate 10. The pad oxide layer 12 will typically have a thickness of approximately 300 angstroms. A nitride layer 14 is deposited over the pad oxide layer. The nitride layer 14 will typically have a thickness of between approximately 100-3000 angstroms.

Referring to Figure 2, the nitride layer 14 and pad oxide layer 12 are patterned and etched to form an opening 18 exposing a portion of the underlying substrate 10. The width of the opening 18 needs to be approximately 0.1 micron. If the opening 18 is wider than 0.1 micron, a conformal oxide layer 16 may be deposited over the nitride layer 14 and in the opening 18.

Referring to Figure 3, an etchback of the conformal oxide layer 16 is performed to form sidewall oxide spacers 20 in the opening to decrease the width of the opening to approximately 0.1 micron. The substrate exposed in the opening 18 is anisotropically etched to form a first trench region 22. The depth of region 22 is typically between approximately 1000-5000 angstroms.

Referring to Figure 4, a thermal oxide layer 24 is grown over the exposed substrate in the first trench region 22. Typically, the thickness of the oxide layer 24 is between approximately 100 to 500 angstroms.

Referring to Figure 5, the thermal oxide layer 24 is etched to the substrate in the first trench region 22. This etch process may be done by a sputter etch. The substrate is then isotropically etched to form a second trench region 26. Trench region 26 will typically have a depth of between approximately 1000 to 5000 angstroms. The isotropic etch typically is a wet etch or a plasma etch. The first trench region 22 must be deep enough that when the second trench region is etched, there is no penetration of the second region into an active area along the upper surface of the substrate where a device (not shown) will subsequently be made. A channel stop region 27 may be implanted into the substrate under the second trench regions, if necessary, to prevent unwanted inversion. The remaining thermal oxide layer 24 and the oxide sidewall spacers 20, if formed, are removed. The nitride layer 14 and pad oxide layer 12 are also removed.

Referring to Figure 6, a thin oxide passivation layer 28 is grown over the substrate and in the trench. Oxide layer 28 typically has a thickness of between approximately 50 to 200 angstroms. Layer 28 will protect the substrate during subsequent processes. An insulating layer 30 is formed over the passivating oxide layer 28 and in the trench. Insulating layer 30 may be spin-on-glass formed to a depth of between approximately 3000 to 20000 angstroms. Layer 30 may be any material which can be formed so as to have a planar upper surface regardless of the underlying topography.

Referring to Figure 7, an etchback of the insulating layer and the oxide passivation layer is performed to expose active areas in the substrate where devices will be subsequently made. Before the etchback is performed, the spin-on-glass insulating layer 30 may be cured by heating at approximately 800 degrees C. The curing process will prevent outgassing during subsequent processing steps. A possible disadvantage of using spin-on-glass may be that it will not fill the trench if the trench is too deep.

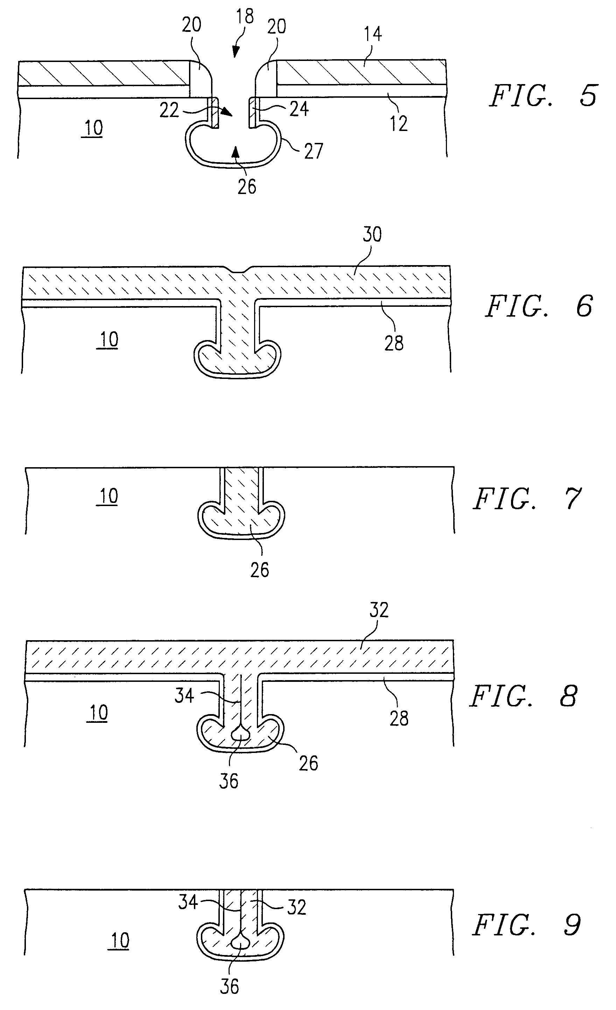

Referring to Figure 8, an alternative insulating material may be oxide 32 formed by chemical vapor deposition. Depending on the depth of the trench, the oxide may be deposited to a depth equal to one-half of the width of the trench, shown as forming along the sidewalls of the trench and meeting in the middle of the trench at 34. A void 36 may occur during the deposition process. As above, an etchback is performed on the oxide 32 and oxide 28, resulting in the structure shown in Figure 9.

At subsequent stages, devices (not shown) will be formed in the active areas in the substrate adjacent to the trench. The width of the trench preferably allows the devices to be close together to maximize packing density. The path around the trench should be long enough to prevent leakage between the adjacent devices. Although the width of the trench is only approximately 0.1 micron, the effective leakage path is preferably a minimum of between approximately 0.7 to 0.9 micron.

While the invention has been particularly shown and described with reference to a preferred embodiment, it will be understood by those skilled in the art that various changes in form and detail may be made therein without departing from the spirit and scope of the invention.

The present invention may provide a method, wherein the insulating layer has a thickness of between approximately 3000 to 20000 angstroms.

The present invention may provide a method, wherein the exposed portion of the substrate has a width of approximately 0.1 micron.

The present invention may provide a method, wherein the pad oxide layer has a thickness of approximately 300 angstroms.

The present invention may provide a method, wherein the nitride layer has a thickness of between approximately 100-3000 angstroms.

The present invention may provide a method, wherein the anisotropic etch forms the first trench region having a width of between approximately 1000 to 5000 angstroms.

The present invention may provide a method, wherein the thermal oxide layer has a thickness of between approximately 100 to 500 angstroms.

The present invention may provide a method, wherein the isotropic etch forms the second trench region having a thickness of between approximately 1000 to 5000 angstroms.

The present invention may provide a method, wherein the isotropic etch is a wet etch.

The present invention may provide a method, wherein the isotropic etch is a plasma etch.

The present invention may provide a method, wherein the dielectric layer has a thickness of between approximately 3000 to 20000 angstroms.

The present invention may provide a structure, wherein the first region has a depth of between approximately 1000-5000 angstroms.

The present invention may provide a structure, wherein the second region has a depth of between approximately 1000-5000 angstroms.

## Claims

1. A method of forming an isolation region, comprising the steps of:
forming a first trench region in a substrate having vertical sidewalls extending downward from an upper surface of the substrate;
forming a second trench region extending outward and downward from a lower portion of the first region; and,
forming an insulating layer in a portion of the first and second regions.

2. The method of Claim 1, wherein the first trench region is formed by an anisotropic etch.

3. The method of Claim 1, wherein the second trench region is formed by an isotropic etch.

4. The method of Claim 3, wherein the depth of the first trench region is such that during the isotropic etch of the second trench region, the width of the second region remains only in the substrate.

5. A method of forming an isolation region of a semiconductor integrated circuit, comprising the steps of:
forming a pad oxide layer over a substrate;
forming a nitride layer over the pad oxide;
patterning and etching the pad oxide layer and nitride layer to form an opening exposing a portion of the substrate;
anisotropically etching the exposed substrate in the opening to form a first trench region;
growing a thermal oxide layer over the exposed substrate in the first trench region;
etching the thermal oxide layer to expose the substrate in the bottom of the first trench region;
isotropically etching the substrate in the bottom of the first trench region to form a second trench region;
removing the remaining thermal oxide layer;
removing the nitride and pad oxide layers;
growing an oxide passivation layer over the substrate and in the first and second trench regions;
forming a dielectric layer over the passivation layer and in a portion of the first and second trench regions; and,
performing an etchback of the dielectric layer to expose a portion of the substrate.

6. The method of Claim 5, further comprising the step of:
forming a conformal oxide layer over the nitride layer and in the opening; and,
performing an etchback of the conformal oxide layer to form oxide spacers on the sidewalls of the nitride and pad oxide layers in the opening exposing a smaller portion of the substrate in the opening.

7. The method of Claim 6, further comprising the step of:
removing the oxide spacers before growing the oxide passivation layer.

8. The method of Claim 5, further comprising the step of:
implanting a channel stop in the first and second trenches after isotropically etching the second trench region.

9. The method of Claim 1 or 6, wherein the insulating or dielectric layer is spin-on-glass.

10. The method of Claim 9, further comprising the step of:
curing the spin-on-glass by heating the spin-on-glass at approximately 800 degrees C before the etchback step.

11. The method of Claim 1 or 5, wherein the dielectric layer is oxide.

12. The method of Claim 11, wherein the oxide is formed by chemical vapor deposition.

13. A structure consisting of a portion of a semiconductor integrated circuit, comprising:
a substrate having an upper surface;
an opening in the substrate having a first and a second region wherein the first region has vertical sidewalls extending downward from the upper surface and wherein the second region extends outward and downward from a lower portion of the first region; and,
an insulating layer in the opening.

14. The structure of Claim 13, wherein the insulating layer forms a planar upper surface.

15. The structure of Claim 13, wherein the insulating layer comprises a cured spin-on-glass.

16. The structure of Claim 13, wherein the insulating layer comprises a chemical vapor deposited oxide.
